(19) Europäisches Patentamt
European Patent Office
Office européen des brevets

(11) **EP 3 147 683 B1**

(12) **EUROPEAN PATENT SPECIFICATION**

(45) Date of publication and mention
of the grant of the patent:
**17.06.2020 Bulletin 2020/25**

(51) Int Cl.:
***G01S 3/02*** *(2006.01)*

(21) Application number: **15186670.4**

(22) Date of filing: **24.09.2015**

(54) **MEASURING DEVICE AND MEASURING METHOD FOR SYSTEMATIC ERROR DETECTION**

MESSVORRICHTUNG UND MESSVERFAHREN ZUR SYSTEMATISCHEN FEHLERERKENNUNG

DISPOSITIF ET PROCÉDÉ DE MESURE POUR DÉTECTION D'ERREUR SYSTÉMATIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**29.03.2017 Bulletin 2017/13**

(73) Proprietor: **Rohde & Schwarz GmbH & Co. KG
81671 München (DE)**

(72) Inventor: **Bartko, Hendrik
80634 Munich (DE)**

(74) Representative: **Körfer, Thomas
Mitscherlich PartmbB
Patent- und Rechtsanwälte
Sonnenstrasse 33
80331 München (DE)**

(56) References cited:
**WO-A1-2014/135196      US-A- 5 457 466
US-A- 5 526 001          US-A1- 2008 247 274
US-B1- 8 121 225**

**Description**

The invention relates to determining systematic errors in measuring signals of at least two antennas, especially in direction finding applications.

When determining the direction of origin of signals, in the ideal case, the signal travels directly from the signal source to the measuring device determining the direction of origin. This ideal case though cannot always be met in practice. In practice, multi-path-propagation and other effects, which lead to systematic errors can occur. This negatively effects the determining of the direction of origin. Significant errors in the determined direction of origin can result from the above-described effects.

The international patent application WO 2014/135196 A1 already shows an effective measuring device and an effective method for direction finding. This measuring device and method are, however, affected by the above-mentioned problems.

The document US 5 526 001 A shows a tracking system taking the bearing of a tracking target into account.

The document US 5 457 466 A shows an emitter azimuth and elevation direction finding system using only linear interferometer arrays.

Accordingly, the object of the invention is to provide a measuring device and measuring method for detecting systematic errors in measuring signals.

The object is solved by the features of claim 1 for the device and claim 13 for the method. Further it is solved by the features of the claim 14 for the associated computer program. The dependent claims contain further developments.

An inventive measuring device comprises a processing unit, a first antenna adapted to receive a first signal, and a second antenna, adapted to receive a second signal. The processing unit comprises a baseline unit adapted to determine a baseline variance of a first variable and/or a second variable, while the first signal and the second signal are not received, taking only background noise into consideration for determining the baseline variance of the first variable and/or the second variable. Moreover, it comprises a variance unit adapted to determine a variance of the first variable and/or the second variable. The first variable and the second variable are each at least initially derived from at least the first signal and the second signal. The processing unit furthermore comprises an error unit, adapted to determine whether a systematic error is present, based on the baseline variance and the variance of the first variable and/or the second variable. It is thereby possible to determine, if a systematic error is present. In the case of direction finding applications, it is thereby possible, to determine, if a determined direction is correct or might be incorrect.

The measuring device is adapted to measure an electromagnetic signal. The first antenna is then adapted to receive the electromagnetic signal as the first reception signal. The second antenna is then adapted to receive the electromagnetic signal as the second reception signal. The error unit is adapted to determine, if a systematic error is present within the electromagnetic signal. It is thereby possible to determine the presence of systematic errors within the electromagnetic signal.

The baseline unit is adapted to determine the baseline variance of the first variable and/or the second variable while the electromagnetic signal is not present. In this case, the variance unit is adapted to determine the variance of the first variable and/or the second variable, while the electromagnetic signal is present. It is thereby possible to very accurately determine the baseline variance and the variance.

Advantageously, the error unit is adapted to determine at least one variance quotient by dividing the variance of the first variable by the baseline variance of the first variable and/or by dividing the variance of the second variable by the baseline variance of the second variable. It is moreover adapted to compare the at least one variance quotient with at least one variance threshold. Furthermore, it is adapted to determine the presence of a systematic error, if the at least one variance quotient is above the at least one variance threshold and to determine no presence of a systematic error, if the at least one variance quotient is below the at least one variance threshold. An especially accurate and simple determining of the presence of systematic errors is thereby possible.

Advantageously, the processing unit comprises a threshold unit, which is adapted to determine the at least one variance threshold based upon a power of the first signal and/or a power of the second signal and/or a number of simultaneously received signals and/or a number of determined locations of origin of received signals and/or a type of surroundings of the measuring device and/or an orientation of the measuring device and/or an availability of computational resources. By dynamically determining the variance threshold, an especially accurate processing is possible.

Further advantageously, the first variable is a ratio of a power of a measuring point of the first signal and a power of a simultaneous measuring point of the second signal. The second variable then is a phase difference of a measuring point of the first signal and a simultaneous measuring point of the second signal. By use of these variables, an especially accurate and simple determining of the presence of systematic errors is possible.

Advantageously, the baseline unit is adapted to determine the baseline variance of the first variable as

$$\sigma_{soll}^{2}\left(r_{mess,kl}\right) = r_{mess,kl}\left(r_{mess,kl} + 1\right)\frac{2P_{noise}}{\sum\limits_{i=1}^{M} P_{mess,l,i}}$$

and to determine the baseline variance of the second variable as

$$\sigma_{soll}^{2}\left(\Delta\varphi_{mess,kl}\right) = \frac{r_{mess,kl} + 1}{2r_{mess,kl}}\frac{P_{noise}}{\sum\limits_{i=1}^{M} P_{mess,l,i}} \quad .$$

$\sigma_{soll}^{2}(r_{mess,kl})$ is the baseline variance of the first variable,
$r_{mess,kl}$ is the first variable - a ratio of a reception power of the first signal and the second signal,
$k$ is an index indicating the first signal,
$l$ is an index indicating the second signal,
$P_{noise}$ is a noise power,
$P_{mess,l,i}$ is a power of the electronic signal without noise,
$i$ is an index of a number of values of the first signal and the second signal taken into account,
$M$ is a number of the number of values of the first signal and the second signal taken into account,
$\sigma_{soll}^{2}(\Delta\varphi_{mess,kl})$ is the baseline variance of the first variable, and
$\Delta\varphi_{mess,kl}$ is the second variable - a phase difference of the phase of the first signal and the phase of the second signal.

An especially accurate and simple determining of the baseline variances is thereby possible.

Further advantageously, the variance unit is adapted to determine the variance of the first variable as follows:

$$V_{mess,k,i} = I_{mess,k,i} + iQ_{mess,k,i}$$

$$P_{mess,k,i} = I_{mess,k,i}^{2} + Q_{mess,k,i}^{2} - P_{noise}$$

$$\sigma_{ist}^{2}\left(r_{mess,kl}\right) = \left(r_{mess,kl}^{2} + 1\right)\frac{\sum\limits_{i=1}^{M}\left(P_{mess,k,i} - r_{mess,kl}P_{mess,l,i}\right)^{2}}{\left[\left(\sum\limits_{i=1}^{M} P_{mess,k,i}\right)^{2} + \left(\sum\limits_{i=1}^{M} P_{mess,l,i}\right)^{2}\right]}$$

$$r_{mess,kl} = \frac{\sum\limits_{i=1}^{M} P_{k,obs,n}}{\sum\limits_{i=1}^{M} P_{l,obs,n}} \quad .$$

Moreover, the variance unit is adapted to determine the variance of the second variable as follows:

$$V_{mess,k,i} = I_{mess,k,i} + iQ_{mess,k,i}$$

$$P_{mess,k,i} = I_{mess,k,i}^{2} + Q_{mess,k,i}^{2} - P_{noise}$$

$$\sigma_{ist}^{\,2}\!\left(\Delta\varphi_{mess,kl}\right)=\frac{\displaystyle\sum_{i=1}^{M}\left[\Im_{kl,i}-\tan\!\left(\Delta\varphi_{mess,kl}\right)\!\Re_{kl,i}\right]^{2}}{\left(\tan^{2}\!\left(\Delta\varphi_{mess,kl}\right)+1\right)\!\left[\left(\displaystyle\sum_{i=1}^{M}\Re_{kl,i}\right)^{2}+\left(\displaystyle\sum_{i=1}^{M}\Im_{kl,i}\right)^{2}\right]}$$

$$\Im_{kl,n}=I_{k,i}Q_{l,i}-I_{l,i}Q_{k,i}$$

$$\Re_{kl,i}=I_{k,i}I_{l,i}+Q_{k,i}Q_{l,i}$$

$$\Delta\varphi_{mess,ij}=\arctan\!\left[\sum_{i=1}^{M}\Im_{kl,i}\,\Big/\,\sum_{i=1}^{M}\Re_{kl,i}\right]\,.$$

Especially,

$V_{mess,k,i}$ is an antenna voltage of antenna k,

$I_{mess,k,i}$ is an inphase component of the antenna voltage of antenna k,

$Q_{mess,k,i}$ is a quadrature component of the antenna voltage of antenna k,

$P_{mess,k,i}$ is a power of the electronic signal without noise,

$P_{noise}$ is a noise power,

$\sigma_{ist}^{2}(r_{mess,kl})$ is the variance of the first variable,

$r_{mess,kl}$ is the first variable - a ratio of a reception power of the first signal and the second signal,

$M$ is a number of the number of values of the first signal and the second signal taken into account,

$i$ is an index of a number of values of the first signal and the second signal taken into account,

$k$ is an index indicating the first signal,

$l$ is an index indicating the second signal,

$P_{k,obs,n}$ is an observed power at antenna k,

$P_{l,obs,n}$ is an observed power at antenna 1,

$\sigma_{ist}^{2}(\Delta\varphi_{mess,kl})$ is the variance of the second variable,

$\Delta\varphi_{mess,kl}$ is the second variable - a phase difference of the phase of the first signal and the phase of the second signal,

$I_{k,i}$ is an inphase component of the antenna voltage of antenna k,

$Q_{l,i}$ is a quadrature component of the antenna voltage of antenna 1,

$I_{l,i}$ is an inphase component of the antenna voltage of antenna 1,

$Q_{k,i}$ is a quadrature component of the antenna voltage of antenna k,

$\Im_{kl,i}$ is a first auxiliary variable, and

$\Re_{kl,i}$ is a second auxiliary variable.

It is thereby possible, to determine the variance of the first and second variable in an especially accurate and simple manner.

Advantageously, the measuring device comprises a third antenna, adapted to receive a third signal. Especially, the third antenna receives the electronic signal as this third signal. The first variable and the second variable are successively derived from the first signal and the second signal, the first signal and the third signal, and the second signal and the third signal. The baseline unit, the variance unit and the error unit are then adapted to perform their respective processing steps successively for the first signal and the second signal, the first signal and the third signal, and the second signal and the third signal. Thereby, the same processing is performed three times for three different antenna pairs. A significant increase in accuracy of the determining of the systematic errors is thereby possible. This is especially the case, if the results of the determining of the systematic errors are OR-connected. This means that as soon as one of the error determination steps of the error unit for one of the possible antenna pairs shows a systematic error, the respective signal is considered as comprising a systematic error. Also a processing of more than three antenna pairs is possible.

Alternatively, the measuring device comprises a third antenna adapted to receive a third signal. The first variable and the second variable can be directly derived from the first signal, the second signal and the third signal. In this case, a more complex computation is necessary, but an even more accurate determining of the systematic error is possible. Also a processing of more than three antenna signals is possible.

Advantageously, the measuring device comprises a display unit, adapted to display the presence and the lack of presence of a systematic error within the electromagnetic signal. Alternatively or additionally, the measuring device comprises a communication unit, which is adapted to output information regarding the presence and the lack of presence of a systematic error within the electromagnetic signal to an external device. It is thereby possible to either display or hand on for further processing the determined information regarding the presence or lack of presence of a systematic error within the electromagnetic signal.

Advantageously, the measuring device comprises a direction determining unit adapted to determine from at least the first signal and the second signal, a direction of origin of the electromagnetic signal. It is then possible to determine, if the determined direction of origin is in fact correct or might be prone to a systematic error.

Advantageously, the measuring device furthermore comprises a display unit, adapted to display the direction of origin of the electromagnetic signal, preferably as a line and/or arrow pointing in the direction of the electromagnetic signal, and display the presence and the lack of presence of a systematic error within the electromagnetic signal, preferably as a color and/or shape and/or shading and/or transparency of the line and/or arrow or of a shape attached to the tip of the line and/or arrow. A user thereby can very easily determine, if a determined direction of origin of an electromagnetic signal is prone to systematic error or not.

Further advantageously, the measuring device comprises a display unit, adapted to display the direction of origin of the electromagnetic signal, preferably as a line and/or arrow pointing in the direction of the electromagnetic signal, only if the error unit has determined that a systematic error is not present within the electromagnetic signal. The user is thereby only confronted with determined directions of origin of signals, which are not prone to systematic error. Especially in a situation with a lack of registered signals and directions of origin, this can significantly ease the user workload.

An inventive method comprises receiving by a first antenna, a first signal and receiving by a second antenna, a second signal. Moreover, it comprises determining a baseline variance of a first variable and/or a second variable, while the first signal and the second signal are not received, taking only background noise into consideration for determining the baseline variance of the first variable and/or the second variable, and determining a variance of the first variable and/or the second variable. The first variable and the second variable are each at least initially derived from at least the first signal and the second signal. Moreover, the method comprises determining, if a systematic error is present, based on the baseline variance and the variance of the first variable and/or the second variable. An especially simple and accurate determining of a presence of a systematic error is thereby possible.

An exemplary embodiment of the invention is now further explained by way of example only with respect to the drawings, in which

Fig. 1    shows an embodiment of the inventive measuring device in an overview block diagram;

Fig. 2    shows a block diagram of a detail of an embodiment of the inventive measuring device;

Fig. 3a    shows an embodiment of the inventive measuring device receiving an electromagnetic signal;

Fig. 3b    shows power levels received by antennas of the embodiment of the inventive device over time;

Fig. 3c    shows power levels of antennas of the embodiment of the inventive device with regard to each other;

Fig. 4a    shows an embodiment of the inventive measuring device receiving an electromagnetic signal comprising a multi-path error component;

Fig. 4b    shows power levels of signals received by antennas of the fourth embodiment over time;

Fig. 4c    shows power levels of antennas of an embodiment of the inventive measuring device with regard to each other;

Fig. 5    shows a block diagram of a detail of an embodiment of the inventive measuring device;

Fig. 6    shows block diagram of a detail of an embodiment of the inventive measuring device;

Fig. 7    shows display content of another embodiment of the inventive measuring device, and

Fig. 8    shows an exemplary embodiment of the inventive measuring method in a flow diagram.

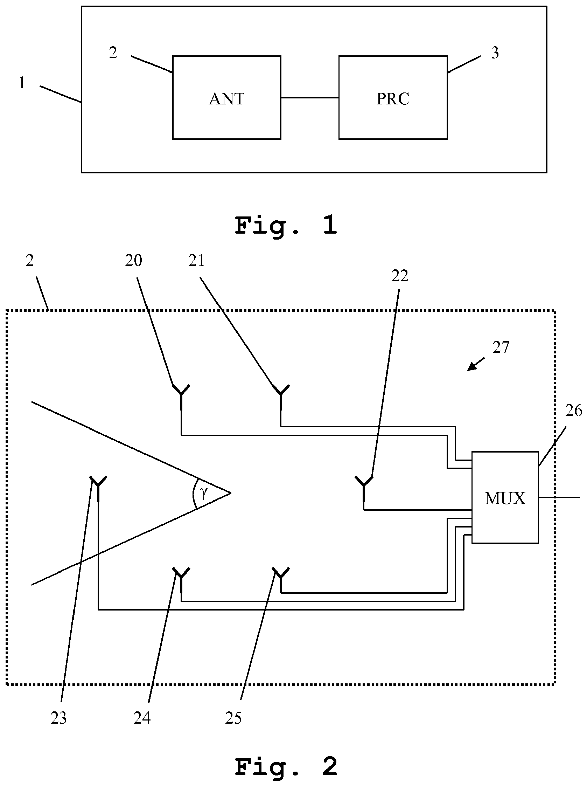

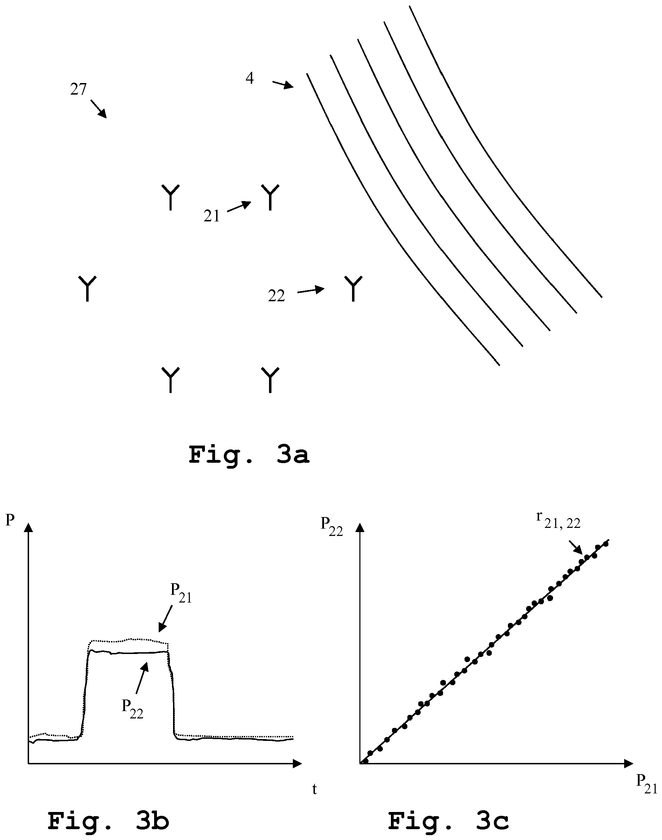

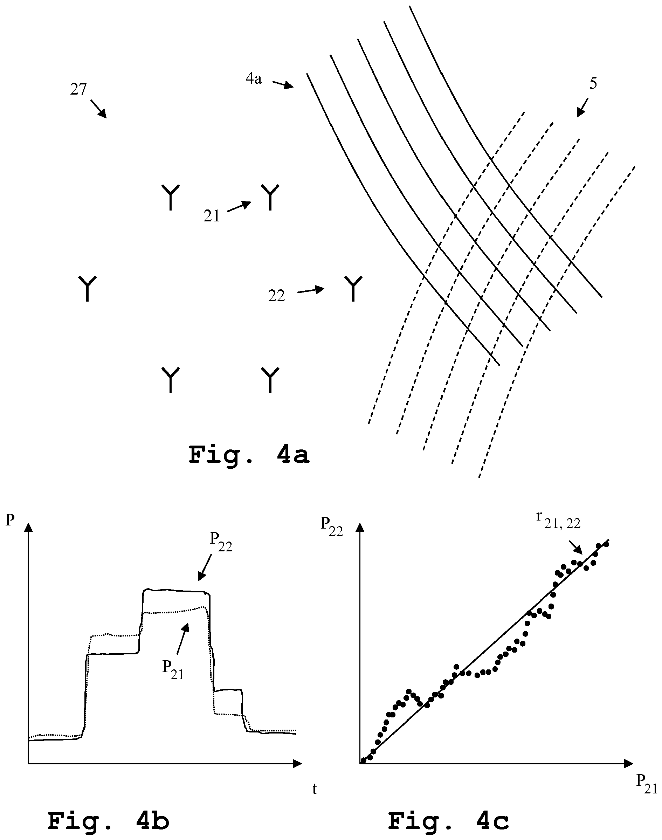

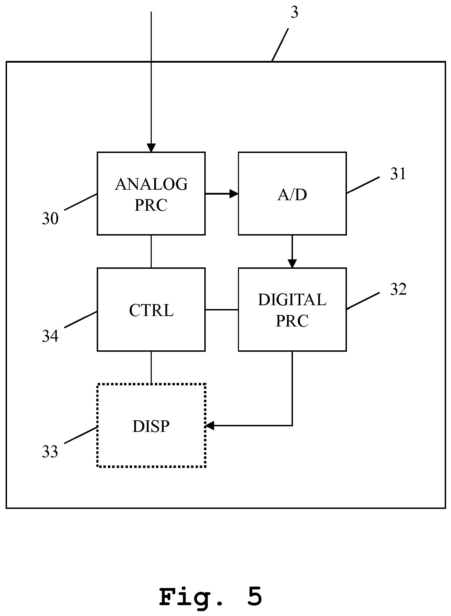

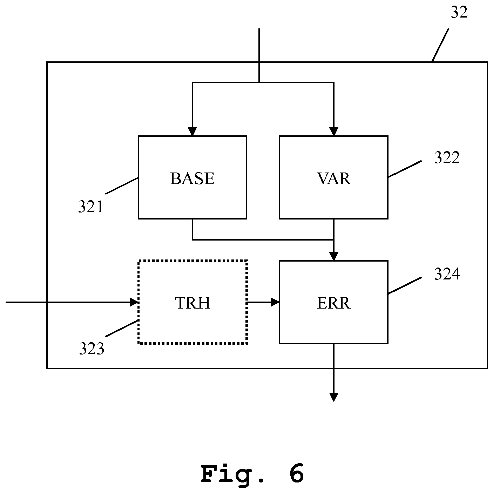

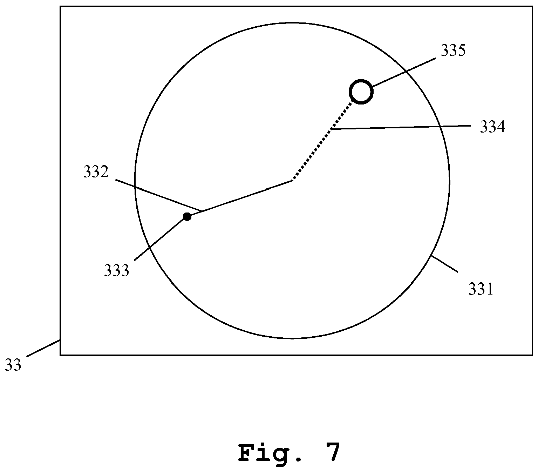

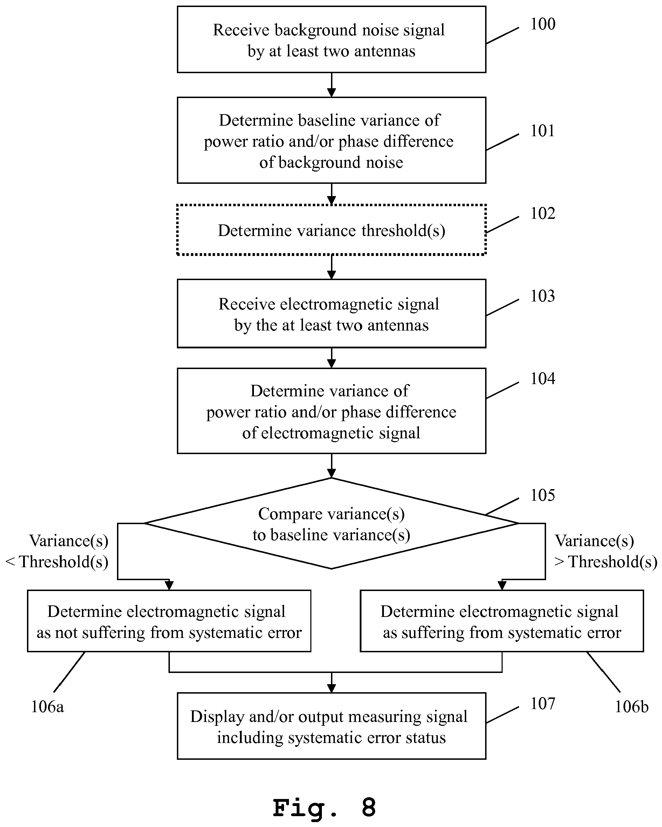

First we demonstrate the general construction of embodiments of the inventive measuring device along Fig. 1 - 2. Along Fig. 3a, 3b, 3c, 4a, 4b and 4c, the problem underlying the present invention and the function of different embodiments of the inventive measuring device and method are discussed in detail. Along Fig. 5 and Fig. 6, the detailed construction of embodiments of the inventive measuring device and their respective functions are described. Along Fig. 7, possible ways of displaying measuring results are discussed. Finally, with regard to Fig. 8, an embodiment of the inventive measuring method is discussed in detail. Similar entities and reference numbers in different figures have been partially omitted.

In Fig. 1, an embodiment of the inventive measuring device 1 is shown. The inventive measuring device comprises an antenna unit 2 and connected to it a processing unit 3. An electromagnetic signal is received by the antenna unit 2 and processed by the processing unit 3. The processing unit 3 determines optionally the direction of origin of the electromagnetic signal and displays it.

Moreover, the processing unit 3 determines, if the electromagnetic signal received by the antenna unit 2 comprises systematic errors, for example originating from multi-path-propagation.

Regarding the construction and function of the antenna unit 2, it is referred to Fig. 2. Regarding the construction and function of the processing unit 3, it is referred to Fig. 5 and Fig. 6.

The electromagnetic signals detected by the inventive measuring device or inventive measuring method are, for example, radar pulses or radio transmissions.

Fig. 2 shows the inner workings of the antenna unit 2 of Fig. 1. The antenna unit 2 comprises an antenna array 27 comprising a plurality of antennas 20-25, which each are optionally connected to a multiplexing unit 26. The multiplexing unit 26 is set up for connecting a number of antennas out of the total available antennas 20-25 to the processing unit 3 of Fig. 1. The number of connected antennas can be pre-specified or can be set by the processing unit 3. Especially a connection of two or three antennas is possible. Also a simultaneous connection of any other number of antennas is possible.

For example, antennas 20, 23 and 24 are connected by the multiplexing means 26 to the processing unit 3 of Fig. 1. In this case, a receiving angle $\gamma$ is achieved. Within this angle, the direction of incoming electromagnetic signals can be determined. Also a determining of the presence systematic errors within received electromagnetic signals is possible within this angle.

In an alternative embodiment, the multiplexing means 26 can be omitted. In this case, the antenna unit 2 merely comprises the antennas 20-25.

The antenna unit 2 comprises at least two different antennas 20 - 25. Alternatively, at least five different antennas are present. Alternatively, at least ten different antennas are present.

For being able to detect a direction of an incoming signal, at least the signals of two antennas have to be used. This is also the case for determining the presence of systematic errors within the received electromagnetic signals.

In Fig. 3a, an embodiment of the inventive measuring device receiving an electromagnetic signal 4 is shown. Here, only antennas 21, 22 of the antenna array 27 are depicted. It is clearly evident here, that antennas 21 and 22 receive the there-upon incident electromagnetic signal 4 roughly at the same time and with the same power. This can readily be seen in Fig. 3b, where the power of the signals of antenna 21 and antenna 22 are displayed over time.

In Fig. 3c, the power of the respective signals of the antennas 21, 22 are shown with regard to each other. It is clearly evident that they lie very close to a line starting in the origin of the coordinate system. This means that a quotient of the powers received at antenna 21 and antenna 22 only has a very low variance.

In Fig. 4a, a further embodiment of the inventive measuring device receiving an electromagnetic signal 4a is shown. Here, the electromagnetic signal 4a comprises a multi-path-propagation component 5, which arrives from a different direction of origin, since it is reflected, for example by a house. Since now the signal reaches the antennas 21, 22 at a significantly different time, and overlaps with the original line-of-sight electromagnetic signal 4, the antennas 21, 22 receive significantly different signals then shown in Fig. 3b. The signal $P_{21}$, $P_{22}$ received by the respective antennas 21, 22 are shown in Fig. 4b with regard to time. Also they are shown in Fig. 4c with regard to each other. Especially there, it can clearly be seen that they no longer closely adhere to the line starting in the origin. This means that a quotient of the powers received at the antennas 21, 22 has a significantly increased variance then shown in Fig. 3c.

In Fig. 5, the internal construction of the processing unit 3 of Fig. 1 is shown. The processing unit 3 comprises an analog processing unit 30, which is supplied with the signal of the antenna unit 2 of Fig. 1. Moreover, the processing unit 3 comprises an analog-digital-converter 31, which is connected to the analog processing unit 30. The analog-digital-converter 31, again, is connected to a digital processing unit 32, which is connected to a display unit 33. The analog processing unit 30, the digital processing unit 32 and the display unit 33 are connected to a control unit 34, which is set up for controlling these components.

Alternatively, the measuring device 1, more accurately the processing unit 3 does not comprise a display unit 33. In this case, it comprises a communication unit, which is adapted to hand measuring results on to an external device.

Signals from the antenna unit 2 are received by the analog processing unit 30. These signals comprise the signals of the individual antennas 20-25 of Fig. 2 or of some of these antennas 20-25 which are currently connected to the analog processing unit 30 by use of the multiplexing unit 26. Alternatively, the signals of all antennas 20-25 of Fig. 20 can be transmitted to the analog processing unit 30 simultaneously.

The signals received by the analog processing unit 30 are processed by it. For example, an amplification and a power determination can be performed. The resulting signals are handed on to the analog-digital converter 31, which digitizes the signals. The digitized signals are passed to the digital processing unit 32, which perform digital processing.

The digital processing unit 32 determines, if the received electromagnetic signal comprises systematic errors. Regarding the therefore necessary processing it is referred to Fig. 6.

The digital processing unit 32 optionally additionally performs a determination of the direction of the detected electromagnetic signal.

Results of the processing by the digital processing unit 32 are handed on to the display unit 33, which displays the presence of systematic errors or its lack thereof and optionally the direction of the electromagnetic signal.

Regarding the inner workings of the digital processing unit 32, it is referred to Fig. 6. A baseline unit 321 is connected to the analog-digital-converter 31 of Fig. 5. Also, a variance unit 322 is connected to the analog-digital-converter 31 of Fig. 5. The baseline unit 321 and the variance unit 322 are both connected to an error unit 324, which in turn is connected to the display unit 33 of Fig. 5. Optionally, a threshold unit 323 is connected to the error unit 324.

In an exemplary measuring device, a digital measuring voltage $V_{mess,k,i}$ is received:

$$V_{mess,k,i} = A_{mess,k,i} \exp\left(j\phi_{mess,k,i}\right) \quad ,$$

with
k=1...N

| | |
|---|---|
| $A_{mess,k,i}$ | being a measuring amplitude, |
| $\Phi_{mess,k,i}$ | being a measuring phase, |
| k | being an antenna number index, |
| i | being a measuring value index, and |
| N | being a total number of measurements. |

A first variable $r_{mess,kl,i}$ and a second variable $\Delta\Phi_{mess,kl,i}$ are determined:

$$r_{mess,kl,i} = \frac{A_{mess,k,i}}{A_{mess,l,i}}$$

$$\Delta\phi_{mess,kl,i} = \phi_{mess,k,i} - \phi_{mess,l,i}$$

with

| | |
|---|---|
| $r_{mess,kl,i}$ | being a quotient between a measuring amplitude of antenna k and antenna 1, |
| $\Delta\Phi_{mess,kl,i}$ | being a phase difference between a measuring amplitude of antenna k, and antenna 1 |
| k | being an antenna number index, |
| l | being an antenna number index, and |
| i | being a measuring value index. |

A variance of the first variable is then determined as:

$$\sigma^2\left(r_{mess,kl}\right) = \frac{1}{M}\sum_{i=1}^{M}\left[r_{mess,kl,i}\right]^2 - \left[\frac{1}{M}\sum_{i=1}^{M} r_{mess,kl,i}\right]^2$$

with

$\sigma^2(r_{mess,kl})$     being the first variable,

M     being a total number of considered measuring values,

i     being a measuring value index, and

$r_{mess,kl,i}$     being a quotient between a measuring amplitude of antenna k and antenna 1.

A variance of the second variable is determined as:

$$\sigma^2\left(\Delta\phi_{mess,kl}\right) = \frac{1}{M}\sum_{i=1}^{M}\left[\Delta\phi_{mess,kl,i}\right]^2 - \left[\frac{1}{M}\sum_{i=1}^{M}\Delta\phi_{mess,kl,i}\right]^2$$

with

$\sigma^2(\Phi_{mess,kl})$     being the second variable,

M     being a total number of considered measuring values,

i     being a measuring value index, and

$\Phi_{mess,kl,i}$     being a phase difference between antenna k and antenna 1.

Primarily considering the measuring error, it is though not possible to determine, if the electromagnetic signal suffers from systematic error, for example originating in multi-path-propagation.

Therefore, in the embodiments of the present invention, the baseline unit 321 is adapted to determine a baseline variance of a first variable and/or a second variable. The first variable is a ratio of a power of a measuring point of the first signal and a power point of a simultaneous measuring point of the second signal. The second variable is a phase difference of a measuring point of the first signal and a simultaneous measuring point of the second signal. The baseline variance is determined as follows:

$$\sigma_{soll}^{2}\left(r_{mess,kl}\right) = r_{mess,kl}\left(r_{mess,kl}+1\right)\frac{2P_{noise}}{\sum_{i=1}^{M}P_{mess,l,i}}$$

$$\sigma_{soll}^{2}\left(\Delta\varphi_{mess,kl}\right) = \frac{r_{mess,kl}+1}{2r_{mess,kl}}\frac{P_{noise}}{\sum_{i=1}^{M}P_{mess,l,i}}$$

with

$\sigma_{soll}^2(r_{mess,kl})$     being the baseline variance of the first variable,

$r_{mess,kl}$     being the first variable - a ratio of a reception power of the first signal and the second signal,

k     being an index indicating the first signal,

l     being an index indicating the second signal,

$P_{noise}$     being a noise power,

$P_{mess,l,i}$     being a power of the electronic signal without noise,

i     being an index of a number of values of the first signal and the second signal taken into account,

M     being a number of the number of values of the first signal and the second signal taken into account,

$\sigma_{soll}^2(\Delta\varphi_{mess,kl})$     being the baseline variance of the first variable, and

$\Delta\varphi_{mess,kl}$     being the second variable - a phase difference of the phase of the first signal and the phase of the second signal.

This variance is determined, while the electromagnetic signal is not received by the antennas. Therefore, only background noise is taking into consideration for determining the baseline variance of the first and/or second variable.

As soon as the electromagnetic signal is received, the variance unit 322 determines the variance of the first and second variable of the electromagnetic signal. This is done as follows:

$$V_{mess,k,i} = I_{mess,k,i} + iQ_{mess,k,i}$$

$$P_{mess,k,i} = I_{mess,k,i}^2 + Q_{mess,k,i}^2 - P_{noise}$$

$$\sigma_{ist}^2\left(r_{mess,kl}\right) = \left(r_{mess,kl}^2 + 1\right)\frac{\sum_{i=1}^{M}\left(P_{mess,k,i} - r_{mess,kl}P_{mess,l,i}\right)^2}{\left[\left(\sum_{i=1}^{M}P_{mess,k,i}\right)^2 + \left(\sum_{i=1}^{M}P_{mess,l,i}\right)^2\right]}$$

with

$$r_{mess,kl} = \frac{\sum_{i=1}^{M}P_{k,obs,n}}{\sum_{i=1}^{M}P_{l,obs,n}}$$

$$\sigma_{ist}^2\left(\Delta\varphi_{mess,kl}\right) = \frac{\sum_{i=1}^{M}\left[\Im_{kl,i} - \tan\left(\Delta\varphi_{mess,kl}\right)\Re_{kl,i}\right]^2}{\left(\tan^2\left(\Delta\varphi_{mess,kl}\right) + 1\right)\left[\left(\sum_{i=1}^{M}\Re_{kl,i}\right)^2 + \left(\sum_{i=1}^{M}\Im_{kl,i}\right)^2\right]}$$

with

$$\Im_{kl,n} = I_{k,i}Q_{l,i} - I_{l,i}Q_{k,i}$$

$$\Re_{kl,i} = I_{k,i}I_{l,i} + Q_{k,i}Q_{l,i}$$

$$\Delta\varphi_{mess,ij} = \arctan\left[\sum_{i=1}^{M}\Im_{kl,i} \Big/ \sum_{i=1}^{M}\Re_{kl,i}\right]$$

with
$V_{mess,k,i}$     being an antenna voltage of antenna k,
$I_{mess,k,i}$     being an inphase component of the antenna voltage of antenna k,
$Q_{mess,k,i}$     being a quadrature component of the antenna voltage of antenna k,
$P_{mess,k,i}$     being a power of the electronic signal without noise,
$P_{noise}$     being a noise power,
$\sigma_{ist}^2(r_{mess,kl})$     being the variance of the first variable,
$r_{mess,kl}$     being the first variable - a ratio of a reception power of the first signal and the second signal,
$M$     being a number of the number of values of the first signal and the second signal taken into account,
$i$     being an index of a number of values of the first signal and the second signal taken into account,

*k* being an index indicating the first signal,

*l* being an index indicating the second signal,

$P_{k,obs,n}$ being an observed power at antenna k,

$P_{l,obs,n}$ being an observed power at antenna 1,

$\sigma_{ist}^2(\Delta\varphi_{mess,kl})$ being the variance of the second variable,

$\Delta\varphi_{mess,kl}$ being the second variable - a phase difference of the phase of the first signal and the phase of the second signal,

$I_{k,i}$ being an inphase component of the antenna voltage of antenna k,

$Q_{l,i}$ being a quadrature component of the antenna voltage of antenna 1,

$I_{l,i}$ being an inphase component of the antenna voltage of antenna 1,

$Q_{k,i}$ being a quadrature component of the antenna voltage of antenna k,

$\mathfrak{I}_{kl,i}$ being a first auxiliary variable, and

$\mathfrak{R}_{kl,i}$ being a second auxiliary variable.

It is especially important to note that the above-shown implementation is especially suitable to be implemented into a FPGA or multi-purpose processor, since it avoids divisions to a large degree.

Now that a baseline variance of the first and/or second variable is determined and also a variance of the first and/or second variable of the electromagnetic signal are determined, it is possible to determine therefrom, if the electromagnetic signal suffers from systematic errors, for example originating in multi-path-propagation.

This is done by the error unit 324, which is supplied with the baseline variances by the baseline unit 321 and the variances by the variance unit 322. The error unit 324 determines a quotient by dividing the variance of the first variable by the baseline variance of the first variable and/or by dividing the variance of the second variable by the baseline variance of the second variable. This variance quotient is compared to a variance threshold. In case it is above the variance threshold, it is assumed that a systematic error of the electromagnetic signal is present. In case it is below the variance threshold, it is assumed that no systematic error is present. The variance threshold is between 1.5 and 10. Especially, it is between 2 and 5.

Optionally, the variance threshold can be dynamically determined by the threshold unit 323. The threshold unit 323 determines the variance threshold dynamically based upon a number of criteria. One or more of these criteria can be used. The threshold unit 323 determines the variance threshold based upon a power of the first signal and/or a power of the second signal, a number of simultaneously received signals, a number of determined locations of origin of received signals, an availability of computational resources, a type of surrounding of the measuring device and/or an orientation of the measuring device.

Especially, a high power of the first and/or second signal leads to a low variance threshold. A high number of determined locations of origin of received signals leads to a high variance threshold. An availability of computational resources leads to a high variance threshold while a lack of computational resources leads to a low variance threshold. A high number of determined locations of origin of received signals leads to a low variance threshold.

The surroundings of the measuring device can also influence the variance threshold. For example, a rural environment leading to a scarce occurrence of multi-path-propagation results in a low variance threshold, while an urban environment, resulting in an often occurrence of multi-path-propagation leads to a high variance threshold.

Also the orientation of the measuring device can influence the variance threshold. If the measuring device is oriented towards a direction from which the occurrence of an electromagnetic signal is probable, this leads to a high variance threshold. If it is oriented towards a direction with a low probability of the occurrence of an electromagnetic signal, this leads to a low variance threshold.

In Fig. 7, a further embodiment of the inventive measuring device is shown. Here, an exemplary content of the display device 33 is shown. Within a circle 331, lines 332 and 334 are depicted indicating directions of origin of electromagnetic signals. Here, the tips of the lines 332 and 334 are each connected to a shape 333 and 335, which indicates, if the respective originating electromagnetic signal suffers from systematic errors or not. Here, for example the solid shape 333 indicates that the underline electromagnetic signal does not suffer from systematic error, while the outlined shape 335 indicates that the underlined electromagnetic signal suffers from systematic errors. Also, the line 334 is a dashed line, also indicating that the respective underlying electromagnetic signal has been detected to suffer from systematic error. Besides the here-depicted options of indicating systematic error, also a use of color and/or shape and/or shading and/or transparency of the line or an arrow or the shape attached to the tip of the line or arrow is possible.

Finally, in Fig. 8, an embodiment of the inventive measuring method is shown. In a first step 100, a background noise signal is received by at least two antennas. In a second step 101, a baseline variance of a first variable and/or a second variable, especially of a power ratio and/or a phase difference of the background noise signal is determined. In an optional third step 102, variance thresholds are determined, as explained earlier. In a fourth step 103, an electromagnetic signal is received by the at least two antennas. In a fifth step 104, a variance of the first and/or second variable, especially the variance of a power ratio and/or a phase difference of the electromagnetic signal is determined. In a sixth step 105, the variances are compared to the variance threshold. If none of the variances is above the variance threshold, in a seventh step 106a, it is determined that the electromagnetic signal does not suffer from systematic error. If at least one of the variances though is above the respective variance threshold, in an eighth step 106b, it is determined that the electromagnetic signal suffers from systematic error. In a final ninth step 107, the results are either displayed or output to an external device.

The invention is not limited to the examples. The characteristics of the exemplary embodiments can be used in any advantageous combination. All features claimed in the claims and/or described in the description and/or drawn in the drawings can be combined. Especially, all features of the dependent device claims can also be combined with the independent method claim.

**Claims**

1. Measuring device adapted to measure the direction of origin of an electromagnetic signal, comprising a processing unit (32), a first antenna (21), adapted to receive the electromagnetic signal as a first signal, and a second antenna (22), adapted to receive the electromagnetic signal as a second signal,
   wherein the processing unit (32) comprises:

   - a baseline unit (321) adapted to determine a baseline variance of a first variable and/or a second variable, while the first signal and the second signal are not received, taking only background noise into consideration for determining the baseline variance of the first variable and/or the second variable, wherein the first variable is a ratio of a power of a measuring point of the first signal and a power of a simultaneous measuring point of the second signal, and
   the second variable is a phase difference of a measuring point of the first signal and a simultaneous measuring point of the second signal,
   - a variance unit (322) adapted to determine a variance of the first variable and/or the second variable, and
   - an error unit (324), adapted to determine whether a systematic error is present, based on the baseline variance and the variance of the first variable and/or the second variable, wherein the systematic error refers to an error within the electromagnetic signal due to multi-path propagation when determining the direction of origin.

2. Measuring device according to claim 1,
   **characterized in that**
   the error unit (324) is adapted to:

   - determine at least one variance quotient by dividing the variance of the first variable by the baseline variance of the first variable, and/or by dividing the variance of the second variable by the baseline variance of the second variable,
   - compare the at least one variance quotient with at least one variance threshold,
   - determine the presence of a systematic error, if the at least one variance quotient is above the at least one variance threshold, and
   - determine no presence of a systematic error, if the at least one variance quotient is below the at least one variance threshold.

3. Measuring device according to claim 2,
   **characterized in that**
   the processing unit (32) comprises a threshold unit (323), adapted to determine the at least one variance threshold, based upon:

   - a power of the first signal and/or a power of the second signal, and/or
   - a number of simultaneously received signals, and/or
   - a number of determined locations of origin of received signals and/or
   - an availability of computational resources, and/or
   - a type of surrounding of the measuring device, and/or
   - an orientation of the measuring device.

4. Measuring device according to claim 1,

**characterized in that**
wherein the baseline unit (321) is adapted to

- determine the baseline variance of the first variable as

$$\sigma_{soll}^{2}\left(r_{mess,kl}\right)=r_{mess,kl}\left(r_{mess,kl}+1\right)\frac{2P_{noise}}{\sum\limits_{i=1}^{M}P_{mess,l,i}} \quad,$$

and/or
- determine the baseline variance of the second variable as

$$\sigma_{soll}^{2}\left(\Delta\varphi_{mess,kl}\right)=\frac{r_{mess,kl}+1}{2r_{mess,kl}}\frac{P_{noise}}{\sum\limits_{i=1}^{M}P_{mess,l,i}} \quad,$$

wherein

$\sigma_{soll}^{2}(r_{mess,kl})$ is the baseline variance of the first variable,
$r_{mess,kl}$ is the first variable - a ratio of a reception power of the first signal and the second signal,
$k$ is an index indicating the first signal,
$l$ is an index indicating the second signal,
$P_{noise}$ is a noise power,
$P_{mess,l,i}$ is a power of the electronic signal without noise,
$i$ is an index of a number of values of the first signal and the second signal taken into account,
$M$ is a number of the number of values of the first signal and the second signal taken into account,
$\sigma_{soll}^{2}(\Delta\varphi_{mess,kl})$ is the baseline variance of the second variable, and
$\Delta\varphi_{mess,kl}$ is the second variable - a phase difference of the phase of the first signal and the phase of the second signal.

5. Measuring device according to claim 4,
   **characterized in that**
   wherein the variance unit (322) is adapted to

   - determine the variance of the first variable as follows:

$$V_{mess,k,i}=I_{mess,k,i}+iQ_{mess,k,i}$$

$$P_{mess,k,i}=I_{mess,k,i}^{2}+Q_{mess,k,i}^{2}-P_{noise}$$

$$\sigma_{ist}^{2}\left(r_{mess,kl}\right)=\left(r_{mess,kl}^{2}+1\right)\frac{\sum\limits_{i=1}^{M}\left(P_{mess,k,i}-r_{mess,kl}P_{mess,l,i}\right)^{2}}{\left[\left(\sum\limits_{i=1}^{M}P_{mess,k,i}\right)^{2}+\left(\sum\limits_{i=1}^{M}P_{mess,l,i}\right)^{2}\right]}$$

with

$$r_{mess,kl} = \frac{\sum_{i=1}^{M} P_{k,obs,n}}{\sum_{i=1}^{M} P_{l,obs,n}} \quad,$$

and/or

- determine the variance of the second variable as follows:

$$V_{mess,k,i} = I_{mess,k,i} + iQ_{mess,k,i}$$

$$P_{mess,k,i} = I_{mess,k,i}^2 + Q_{mess,k,i}^2 - P_{noise}$$

$$\sigma_{ist}^2\left(\Delta\varphi_{mess,kl}\right) = \frac{\sum_{i=1}^{M}\left[\Im_{kl,i} - \tan\left(\Delta\varphi_{mess,kl}\right)\Re_{kl,i}\right]^2}{\left(\tan^2\left(\Delta\varphi_{mess,kl}\right)+1\right)\left[\left(\sum_{i=1}^{M}\Re_{kl,i}\right)^2 + \left(\sum_{i=1}^{M}\Im_{kl,i}\right)^2\right]}$$

with

$$\Im_{kl,n} = I_{k,i}Q_{l,i} - I_{l,i}Q_{k,i}$$

$$\Re_{kl,i} = I_{k,i}I_{l.i} + Q_{k,i}Q_{l,i}$$

$$\Delta\varphi_{mess,ij} = \arctan\left[\sum_{i=1}^{M}\Im_{kl,i} \Big/ \sum_{i=1}^{M}\Re_{kl,i}\right]\quad,$$

wherein

$V_{mess,k,i}$ is an antenna voltage of antenna k,
$I_{mess,k,i}$ is an inphase component of the antenna voltage of antenna k,
$Q_{mess,k,i}$ is a quadrature component of the antenna voltage of antenna k,
$P_{mess,k,i}$ is a power of the electronic signal without noise,
$P_{noise}$ is a noise power,
$\sigma_{ist}^2(r_{mess,kl})$ is the variance of the first variable,
$r_{mess,kl}$ is the first variable - a ratio of a reception power of the first signal and the second signal,
$M$ is a number of the number of values of the first signal and the second signal taken into account,
$i$ is an index of a number of values of the first signal and the second signal taken into account,
$k$ is an index indicating the first signal,
$l$ is an index indicating the second signal,
$P_{k,obs,n}$ is an observed power at antenna k,
$P_{l,obs,n}$ is an observed power at antenna 1,
$\sigma_{ist}^2(\Delta\varphi_{mess,kl})$ is the variance of the second variable,
$\Delta\varphi_{mess,kl}$ is the second variable - a phase difference of the phase of the first signal and the phase of the second signal,
$I_{k,i}$ is an inphase component of the antenna voltage of antenna k,
$Q_{l,i}$ is a quadrature component of the antenna voltage of antenna 1,

$I_{l,i}$ is an inphase component of the antenna voltage of antenna 1,

$Q_{k,i}$ is a quadrature component of the antenna voltage of antenna k,

$\mathfrak{I}_{kl,i}$ is a first auxiliary variable, and

$\mathfrak{R}_{kl,i}$ is a second auxiliary variable.

6. Measuring device according to any of the claims 1 to 5,
**characterized in that**
the measuring device (1) comprises a third antenna, adapted to receive the electromagnetic signal as a third signal, the first variable and the second variable are successively derived from

- the first signal and the second signal,
- the first signal and the third signal, and
- the second signal and the third signal,
the baseline unit (321) is adapted to determine the baseline variance, successively for the first variable and the second variable being successively derived from
- the first signal and the second signal,
- the first signal and the third signal, and
- the second signal and the third signal,
the variance unit (322) is adapted to determine the variance of the first variable and/or the second variable, successively for the first variable and the second variable being successively derived from
- the first signal and the second signal,
- the first signal and the third signal, and
- the second signal and the third signal, and
the error unit (324) is adapted to determine if a systematic error is present, successively based on the baseline variance and the variance of the first variable and/or the second variable being successively derived from
- the first signal and the second signal,
- the first signal and the third signal, and
- the second signal and the third signal.

7. Measuring device according to any of the claims 1 to 5,
**characterized in that**
the measuring device comprises a third antenna, adapted to receive the electromagnetic signal as a third signal, the first variable and the second variable are derived from the first signal, the second signal and the third signal.

8. Measuring device according to any of the claims 1 to 7,
**characterized in that** the measuring device (1) comprises a communication unit, adapted to output information regarding the presence and the lack of presence of a systematic error within the electromagnetic signal (4a) to an external device.

9. Measuring device according to any of the claims 1 to 8,
**characterized in that**
the measuring device (1) comprises a display unit (33), adapted to display the presence and the lack of presence of a systematic error within the electromagnetic signal.

10. Measuring device according to claim 9, **characterized in** the display unit is adapted to display the direction of origin of the electromagnetic signal.

11. Measuring device according to any of claims 1-8, **characterized in that**
the measuring device (1) comprises a display unit (33), adapted to

- display the direction of origin of the electromagnetic signal (4a), preferably as line (332, 334) and/or arrow pointing in the direction of the electromagnetic signal (4a), and
- display the presence and the lack of presence of a systematic error within the electromagnetic signal (4a), preferably as a color and/or shape and/or shading and/or transparency of the line and/or arrow or of a shape (333, 335) attached to a tip of the line and/or arrow.

**12.** Measuring device according to claim 11 **characterized in that**
the display unit (33) is adapted to display the direction of origin of the electromagnetic signal (4a), preferably as line (332) and/or arrow pointing in the direction of the electromagnetic signal (4a), only if the error unit (324) has determined that a systematic error is not present within the electromagnetic signal (4a).

**13.** A method for measuring the direction of origin of an electromagnetic signal, comprising the following steps:

- receiving (100) the electromagnetic signal by a first antenna (21) as a first signal,
- receiving (100) the electromagnetic signal by a second antenna as a second signal,
- determining (101) a baseline variance of a first variable and/or a second variable, while the first signal and the second signal are not received, taking only background noise into consideration for determining the baseline variance of the first variable and/or the second variable, wherein the first variable is a ratio of a power of a measuring point of the first signal and a power of a simultaneous measuring point of the second signal, and the second variable is a phase difference of a measuring point of the first signal and a simultaneous measuring point of the second signal,
- determining (104) a variance of the first variable and/or the second variable, and
- determining (105) whether a systematic error is present, based on the baseline variance and the variance of the first variable and/or the second variable, wherein the systematic error refers to an error within the electromagnetic signal due to multi-path propagation when determining the direction of origin of the electromagnetic signal.

**14.** A computer program with program code means for performing all steps according to claim 13 when the program is executed on a signal processor of a measuring device adapted to measure the direction of origin of an electromagnetic signal, comprising a processing unit (32), a first antenna (21), adapted to receive the electromagnetic signal as a first signal, and a second antenna (22), adapted to receive the electromagnetic signal as a second signal.

**Patentansprüche**

**1.** Messvorrichtung, die zum Messen der Einfallrichtung eines elektromagnetischen Signals ausgebildet ist, mit einer Verarbeitungseinheit (32), einer ersten Antenne (21), die zum Empfangen des elektromagnetischen Signals als ein erstes Signal ausgebildet ist, sowie einer zweiten Antenne (22), die zum Empfangen des elektromagnetischen Signals als ein zweites Signal ausgebildet ist, wobei die Verarbeitungseinheit (32) Folgendes aufweist:

- eine Grundeinheit (321), die zum Bestimmen einer Grundabweichung einer ersten Variablen und/oder einer zweiten Variablen ausgebildet ist, während das erste Signal und das zweite Signal nicht empfangen werden, wobei zum Bestimmen der Grundabweichung der ersten Variablen und/oder der zweiten Variablen nur Hintergrundrauschen berücksichtigt wird, wobei die erste Variable ein Verhältnis einer Leistung eines Messpunktes des ersten Signals und einer Leistung eines gleichzeitigen Messpunktes des zweiten Signals darstellt, und die zweite Variable eine Phasendifferenz eines Messpunktes des ersten Signals und eines gleichzeitigen Messpunktes des zweiten Signals darstellt,
- eine Abweichungseinheit (322), die dazu ausgebildet ist, eine Abweichung der ersten Variablen und/oder der zweiten Variablen zu bestimmen, sowie
- eine Fehlereinheit (324), die dazu ausgebildet ist, auf der Basis der Grundabweichung und der Abweichung der ersten Variablen und/oder der zweiten Variablen zu bestimmen, ob ein systematischer Fehler vorliegt, wobei sich der systematische Fehler auf einen Fehler in dem elektromagnetischen Signal aufgrund von Mehrweg-Ausbreitung bei Bestimmung der Einfallrichtung bezieht.

**2.** Messvorrichtung nach Anspruch 1,
**dadurch gekennzeichnet, dass**
die Fehlereinheit (324) dazu ausgebildet ist:

- mindestens einen Abweichungsquotienten durch Teilen der Abweichung der ersten Variablen durch die Grundabweichung der ersten Variablen und/oder durch Teilen der Abweichung der zweiten Variablen durch die Grundabweichung der zweiten Variablen zu bestimmen,
- den mindestens einen Abweichungsquotienten mit mindestens einem Abweichungsschwellenwert zu vergleichen,
- das Vorliegen eines systematischen Fehlers zu bestimmen, wenn der mindestens eine Abweichungsquotient über dem mindestens einen Abweichungsschwellenwert liegt, und
- ein Nicht-Vorliegen eines systematischen Fehlers zu bestimmen, wenn der mindestens eine Abweichungsquotient unter dem mindestens einen Abweichungsschwellenwert liegt.

3. Messvorrichtung nach Anspruch 2,
**dadurch gekennzeichnet, dass**
die Verarbeitungseinheit (32) eine Schwellenwerteinheit (323) aufweist, die dazu ausgebildet ist, den mindestens einen Abweichungsschwellenwert auf der Basis von:

- einer Leistung des ersten Signals und/oder einer Leistung des zweiten Signals, und/oder
- einer Anzahl von gleichzeitig empfangenen Signalen und/oder
- einer Anzahl von bestimmten Einfallorten empfangener Signale und/oder
- einer Verfügbarkeit von Berechnungsquellen und/oder
- einer Umgebungsart der Messvorrichtung und/oder
- einer Ausrichtung der Messvorrichtung
zu bestimmen.

4. Messvorrichtung nach Anspruch 1,
**dadurch gekennzeichnet, dass**
die Grundeinheit (321) dazu ausgebildet ist,

- die Grundabweichung der ersten Variablen als

$$\sigma_{soll}^2\left(r_{mess,kl}\right)=r_{mess,kl}\left(r_{mess,kl}+1\right)\frac{2P_{noise}}{\sum\limits_{i=1}^{M}P_{mess,l,i}}\,,$$

zu bestimmen und/oder
- die Grundabweichung der zweiten Variablen als

$$\sigma_{soll}^2\left(\Delta\varphi_{mess,kl}\right)=\frac{r_{mess,kl}+1}{2r_{mess,kl}}\frac{P_{noise}}{\sum\limits_{i=1}^{M}P_{mess,l,i}}$$

zu bestimmen,

wobei

$\sigma_{soll}^2(r_{mess,kl})$ die Grundabweichung der ersten Variablen ist,
$r_{mess,kl}$ die erste Variable ist - ein Verhältnis einer Empfangsleistung des ersten Signals und des zweiten Signals,
$k$ ein das erste Signal anzeigender Index ist,
$l$ ein das zweite Signal anzeigender Index ist,
$P_{noise}$ eine Rauschleistung ist,
$P_{mess,l,i}$ eine Leistung des elektronischen Signals ohne Rauschen ist,
$i$ ein Index einer berücksichtigten Anzahl von Werten des ersten Signals und des zweiten Signals ist,
$M$ eine Anzahl der berücksichtigten Anzahl von Werten des ersten Signals und des zweiten Signals ist,
$\sigma_{soll}^2(\Delta\varphi_{mess,kl})$ die Grundabweichung der zweiten Variablen ist und
$\Delta\varphi_{mess,kl}$ die zweite Variable ist - eine Phasendifferenz der Phase des ersten Signals und der Phase des zweiten Signals.

5. Messvorrichtung nach Anspruch 4,
**dadurch gekennzeichnet, dass**
die Abweichungseinheit (322) dazu ausgebildet ist,

- die Abweichung der ersten Variablen wie folgt zu bestimmen:

$$V_{mess,k,i} = I_{mess,k,i} + iQ_{mess,k,i}$$

$$P_{mess,k,i} = I^2_{mess,k,i} + Q^2_{mess,k,i} - P_{noise}$$

$$\sigma_{ist}^2\left(r_{mess,kl}\right) = \left(r_{mess,kl}^2 + 1\right)\frac{\sum_{i=1}^{M}\left(P_{mess,k,i} - r_{mess,kl}P_{mess,l,i}\right)^2}{\left[\left(\sum_{i=1}^{M}P_{mess,k,i}\right)^2 + \left(\sum_{i=1}^{M}P_{mess,l,i}\right)^2\right]}$$

mit

$$r_{mess,kl} = \frac{\sum_{i=1}^{M}P_{k,obs,n}}{\sum_{i=1}^{M}P_{l,obs,n}}$$

und/oder

- die Abweichung der zweiten Variablen wie folgt zu bestimmen:

$$V_{mess,k,i} = I_{mess,k,i} + iQ_{mess,k,i}$$

$$P_{mess,k,i} = I^2_{mess,k,i} + Q^2_{mess,k,i} - P_{noise}$$

$$\sigma_{ist}^2\left(\Delta\varphi_{mess,kl}\right) = \frac{\sum_{i=1}^{M}\left[\Im_{kl,i} - \tan\left(\Delta\varphi_{mess,kl}\right)\Re_{kl,i}\right]^2}{\left(\tan^2\left(\Delta\varphi_{mess,kl}\right) + 1\right)\left[\left(\sum_{i=1}^{M}\Re_{kl,i}\right)^2 + \left(\sum_{i=1}^{M}\Im_{kl,i}\right)^2\right]}$$

mit

$$\Im_{kl,n} = I_{k,i}Q_{l,i} - I_{l,i}Q_{k,i}$$

$$\Re_{kl,i} = I_{k,i}I_{l,i} + Q_{k,i}Q_{l,i}$$

$$\Delta\varphi_{mess,lj} = \arctan\left[\sum_{i=1}^{M}\Im_{kl,i}\middle/\sum_{i=1}^{M}\Re_{kl,i}\right],$$

wobei

$V_{mess,k,i}$ eine Antennenspannung der Antenne k ist,

$I_{mess,k,i}$ eine gleichphasige Komponente der Antennenspannung der Antenne k ist,

$Q_{mess,k,i}$ eine Blindkomponente der Antennenspannung der Antenne k ist,

$P_{mess,k,i}$ eine Leistung des elektronischen Signals ohne Rauschen ist,

$P_{noise}$ eine Rauschleistung ist,

$\sigma_{ist}^2(r_{mes,kl})$ die Abweichung der ersten Variablen ist,

$r_{mess;kl}$ die erste Variable ist - ein Verhältnis einer Empfangsleistung des ersten Signals und des zweiten Signals,

$M$ eine Anzahl der berücksichtigten Anzahl von Werten des ersten Signals und des zweiten Signals ist,

$i$ ein Index einer berücksichtigten Anzahl von Werten des ersten Signals und des zweiten Signals ist,

$k$ ein das erste Signal anzeigender Index ist,

$l$ ein das zweite Signal anzeigender Index ist,

$P_{k,obs,n}$ eine beobachtete Leistung an der Antenne k ist,

$P_{l,obs,n}$ eine beobachtete Leistung an der Antenne l ist,

$\sigma_{ist}^2(\Delta\varphi_{mess,kl})$ die Abweichung der zweiten Variablen ist,

$\Delta\varphi_{mess,kl}$ die zweite Variable ist - eine Phasendifferenz der Phase des ersten Signals und der Phase des zweiten Signals,

$I_{k,i}$ eine gleichphasige Komponente der Antennenspannung der Antenne k ist,

$Q_{l,i}$ eine Blindkomponente der Antennenspannung der Antenne l ist,

$I_{l,i}$ eine gleichphasige Komponente der Antennenspannung der Antenne l ist,

$Q_{k,i}$ eine Blindkomponente der Antennenspannung der Antenne k ist,

$\mathfrak{I}_{kl,i}$ eine erste Hilfsvariable ist, und

$\mathfrak{R}_{kl,i}$ eine zweite Hilfsvariable ist.

6. Messvorrichtung nach einem der Ansprüche 1 bis 5,
**dadurch gekennzeichnet, dass**
die Messvorrichtung (1) eine dritte Antenne aufweist, die dazu ausgebildet ist, das elektromagnetische Signal als ein drittes Signal zu empfangen,
die erste Variable und die zweite Variable nacheinander abgeleitet werden von

- dem ersten Signal und dem zweiten Signal,
- dem ersten Signal und dem dritten Signal sowie
- dem zweiten Signal und dem dritten Signal,
die Grundeinheit (321) dazu ausgebildet ist, die Grundabweichung nacheinander für die erste Variable und die zweite Variable zu bestimmen, wobei diese nacheinander abgeleitet werden von
- dem ersten Signal und dem zweiten Signal,
- dem ersten Signal und dem dritten Signal sowie
- dem zweiten Signal und dem dritten Signal,
die Abweichungseinheit (322) dazu ausgebildet ist, die Abweichung der ersten Variablen und/oder der zweiten Variablen nacheinander für die erste Variable und die zweite Variable zu bestimmen, wobei diese nacheinander abgeleitet werden von
- dem ersten Signal und dem zweiten Signal,
- dem ersten Signal und dem dritten Signal sowie
- dem zweiten Signal und dem dritten Signal, und
die Fehlereinheit (324) dazu ausgebildet ist, zu bestimmen, ob ein systematischer Fehler vorliegt, nacheinander auf der Basis der Grundabweichung und der Abweichung der ersten Variablen und/oder der zweiten Variablen, wobei diese nacheinander abgeleitet werden von
- dem ersten Signal und dem zweiten Signal,
- dem ersten Signal und dem dritten Signal sowie
- dem zweiten Signal und dem dritten Signal.

7. Messvorrichtung nach einem der Ansprüche 1 bis 5,
**dadurch gekennzeichnet, dass**
die Messvorrichtung eine dritte Antenne aufweist, die dazu ausgebildet ist, das elektromagnetische Signal als ein drittes Signal zu empfangen,

die erste Variable und die zweite Variable von dem ersten Signal, dem zweiten Signal und dem dritten Signal abgeleitet werden.

8. Messvorrichtung nach einem der Ansprüche 1 bis 7,
**dadurch gekennzeichnet, dass**
die Messvorrichtung (1) eine Kommunikationseinheit aufweist, die dazu ausgebildet ist, Informationen hinsichtlich des Vorliegens und des Nichtvorliegens eines systematischen Fehlers in dem elektromagnetischen Signal (4a) an ein externes Gerät auszugeben.

9. Messvorrichtung nach einem der Ansprüche 1 bis 8,
**dadurch gekennzeichnet, dass**
die Messvorrichtung (1) eine Anzeigeeinheit (33) aufweist, die dazu ausgebildet ist, das Vorliegen und das Nichtvorliegen eines systematischen Fehlers in dem elektromagnetischen Signal anzuzeigen.

10. Messvorrichtung nach Anspruch 9,
**dadurch gekennzeichnet, dass**
die Anzeigeeinheit dazu ausgebildet ist, die Einfallrichtung des elektromagnetischen Signals anzuzeigen.

11. Messvorrichtung nach einem der Ansprüche 1 bis 8,
**dadurch gekennzeichnet, dass**
die Messvorrichtung (1) eine Anzeigeeinheit (33) aufweist, die dazu ausgebildet ist,

- die Einfallrichtung des elektromagnetischen Signals (4a) anzuzeigen, vorzugsweise als Linie (332, 334) und/oder Pfeil, die/der in die Richtung des elektromagnetischen Signals (4a) weist, und
- das Vorliegen und das Nichtvorliegen eines systematischen Fehlers in dem elektromagnetischen Signal (4a) anzuzeigen, vorzugsweise als eine Farbe und/oder Form und/oder Tönung und/oder Transparenz der Linie und/oder des Pfeils oder einer an einer Spitze der Linie und/oder des Pfeils angebrachten Form (333, 335).

12. Messvorrichtung nach Anspruch 11,
**dadurch gekennzeichnet, dass**
die Anzeigeeinheit (33) dazu ausgebildet ist, die Einfallrichtung des elektromagnetischen Signals (4a) anzuzeigen, vorzugsweise als Linie (332) und/oder Pfeil, die/der in die Richtung des elektromagnetischen Signals (4a) weist, nur wenn die Fehlereinheit (324) bestimmt hat, dass kein systematischer Fehler in dem elektromagnetischen Signal (4a) vorliegt.

13. Verfahren zum Messen der Einfallrichtung eines elektromagnetischen Signals, mit den folgenden Schritten:

- Empfangen (100) des elektromagnetischen Signals durch eine erste Antenne (21) als ein erstes Signal,
- Empfangen (100) des elektromagnetischen Signals durch eine zweite Antenne als ein zweites Signal,
- Bestimmen (101) einer Grundabweichung einer ersten Variablen und/oder einer zweiten Variablen, während das erste Signal und das zweite Signal nicht empfangen werden, unter Berücksichtigung lediglich von Hintergrundrauschen zum Bestimmen der Grundabweichung der ersten Variablen und/oder der zweiten Variablen, wobei die erste Variable ein Verhältnis einer Leistung eines Messpunktes des ersten Signals und einer Leistung eines gleichzeitigen Messpunktes des zweiten Signals ist und die zweite Variable eine Phasendifferenz eines Messpunktes des ersten Signals und eines gleichzeitigen Messpunktes des zweiten Signals ist,
- Bestimmen (104) einer Abweichung der ersten Variablen und/oder der zweiten Variablen und
- Bestimmen (105), auf der Basis der Grundabweichung und der Abweichung der ersten Variablen und/oder der zweiten Variablen, ob ein systematischer Fehler vorliegt, wobei sich der systematische Fehler auf einen Fehler in dem elektromagnetischen Signal aufgrund von Mehrweg-Ausbreitung bei Bestimmung der Einfallrichtung des elektromagnetischen Signals bezieht.

14. Computerprogramm mit Programmcodeeinrichtung zum Durchführen aller Schritte nach Anspruch 13, wenn das Programm auf einem Signalprozessor einer Messvorrichtung ausgeführt wird, welche dazu ausgebildet ist, die Einfallrichtung eines elektromagnetischen Signals zu messen, mit einer Verarbeitungseinheit (32), einer ersten Antenne (21), die zum Empfangen des elektromagnetischen Signals als ein erstes Signal ausgebildet ist, und einer zweiten Antenne (22), die zum Empfangen des elektromagnetischen Signals als ein zweites Signal ausgebildet ist.

**Revendications**

1. Dispositif de mesure conçu pour mesurer la direction d'origine d'un signal électromagnétique, comprenant une unité de traitement (32), une première antenne (21), conçue pour recevoir le signal électromagnétique en tant que premier signal, et une deuxième antenne (22), conçue pour recevoir le signal électromagnétique en tant que deuxième signal, dans lequel l'unité de traitement (32) comprend :

   - une unité de ligne de base (321) conçue pour déterminer une variance de ligne de base d'une première variable et/ou d'une deuxième variable, alors que le premier signal et le deuxième signal ne sont pas reçus, en prenant uniquement le bruit de fond en considération pour déterminer la variance de ligne de base de la première variable et/ou de la deuxième variable, dans lequel la première variable est un rapport entre une puissance d'un point de mesure du premier signal et une puissance d'un point de mesure simultané du deuxième signal, et la deuxième variable est une différence de phase entre un point de mesure du premier signal et un point de mesure simultané du deuxième signal,
   - une unité de variance (322) conçue pour déterminer une variance de la première variable et/ou de la deuxième variable, et
   - une unité d'erreur (324), conçue pour déterminer si une erreur systématique est présente, sur la base de la variance de ligne de base et de la variance de la première variable et/ou de la deuxième variable, dans lequel l'erreur systématique fait référence à une erreur dans le signal électromagnétique due à une propagation multi-titrajet lors de la détermination de la direction d'origine.

2. Dispositif de mesure selon la revendication 1,
   **caractérisé en ce que**
   l'unité d'erreur (324) est conçue pour :

   - déterminer au moins un quotient de variance en divisant la variance de la première variable par la variance de ligne de base de la première variable, et/ou en divisant la variance de la deuxième variable par la variance de ligne de base de la deuxième variable,
   - comparer ledit au moins un quotient de variance avec au moins un seuil de variance,
   - déterminer la présence d'une erreur systématique, si ledit au moins un quotient de variance est au-dessus dudit au moins un seuil de variance, et
   - déterminer l'absence d'une erreur systématique, si ledit au moins un quotient de variance est au-dessous dudit au moins un seuil de variance.

3. Dispositif de mesure selon la revendication 2,
   **caractérisé en ce que**
   l'unité de traitement (32) comprend une unité de seuil (323), conçue pour déterminer ledit au moins un seuil de variance, sur la base :

   - d'une puissance du premier signal et/ou d'une puissance du deuxième signal, et/ou
   - d'un nombre de signaux reçus simultanément, et/ou
   - d'un nombre d'emplacements déterminés d'origine des signaux reçus, et/ou
   - d'une disponibilité de ressources de calcul, et/ou
   - d'un type d'environnement du dispositif de mesure, et/ou
   - d'une orientation du dispositif de mesure.

4. Dispositif de mesure selon la revendication 1,
   **caractérisé en ce que**
   l'unité de ligne de base (321) est conçue pour

   - déterminer la variance de ligne de base de la première variable en tant que

$$\sigma_{soll}^2 \left( r_{mess,kl} \right) = r_{mess,kl} \left( r_{mess,kl} + 1 \right) \frac{2 P_{noise}}{\sum\limits_{l=1}^{M} P_{mess,l,i}},$$

et/ou

- déterminer la variance de ligne de base de la deuxième variable en tant que

$$\sigma_{soll}{}^2\left(\Delta\varphi_{mess,kl}\right) = \frac{r_{mess,kl}+1}{2r_{mess,kl}}\frac{P_{noise}}{\sum_{i=1}^{M}P_{mess,l,i}}\quad,$$

où

$\sigma_{soll}{}^2(r_{mess,kl})$ est la variance de ligne de base de la première variable,

$r_{mess,kl}$ est la première variable, un rapport d'une puissance de réception entre le premier signal et le deuxième signal,

k est un indice indiquant le premier signal,

l est un indice indiquant le deuxième signal,

$P_{noise}$ est une puissance de bruit,

$P_{mess,l,i}$ est une puissance du signal électronique sans bruit,

i est un indice d'un nombre de valeurs du premier signal et du deuxième signal pris en compte,

M est un nombre du nombre de valeurs du premier signal et du deuxième signal pris en compte,

$\sigma_{soll}{}^2(\Delta\varphi_{mess,kl})$ est la variance de ligne de base de la deuxième variable, et

$\Delta\varphi_{mess,kl}$ est la deuxième variable, une différence de phase entre la phase du premier signal et la phase du deuxième signal.

5. Dispositif de mesure selon la revendication 4, **caractérisé en ce que**
l'unité de variance (322) est conçue pour

- déterminer la variance de la première variable comme suit :

$$V_{mess,k,i} = I_{mess,k,i} + iQ_{mess,k,i}$$

$$P_{mess,k,i} = I^2_{mess,k,i} + Q^2_{mess,k,i} - P_{noise}$$

$$\sigma_{ist}{}^2\left(r_{mess,kl}\right) = \left(r_{mess,kl}{}^2+1\right)\frac{\sum_{i=1}^{M}\left(P_{mess,k,i}-r_{mess,kl}P_{mess,l,i}\right)^2}{\left[\left(\sum_{i=1}^{M}P_{mess,k,i}\right)^2+\left(\sum_{i=1}^{M}P_{mess,l,i}\right)^2\right]}$$

avec

$$r_{mess,kl} = \frac{\sum_{i=1}^{M}P_{k,obs,n}}{\sum_{i=1}^{M}P_{l,obs,n}}\quad,$$

et/ou

- déterminer la variance de la deuxième variable comme suit :

$$V_{mess,k,i} = I_{mess,k,i} + iQ_{mess,k,i}$$

$$P_{mess,k,i} = I_{mess,k,i}^2 + Q_{mess,k,i}^2 - P_{noise}$$

$$\sigma_{ist}^2(\Delta\varphi_{mess,kl}) = \frac{\sum_{i=1}^{M}\left[\mathfrak{I}_{kl,i} - \tan(\Delta\varphi_{mess,kl})\mathfrak{R}_{kl,i}\right]^2}{\left(\tan^2(\Delta\varphi_{mess,kl}) + 1\right)\left[\left(\sum_{i=1}^{M}\mathfrak{R}_{kl,i}\right)^2 + \left(\sum_{i=1}^{M}\mathfrak{I}_{kl,i}\right)^2\right]}$$

avec

$$\mathfrak{I}_{kl,n} = I_{k,i}Q_{l,i} - I_{l,i}Q_{k,i}$$

$$\mathfrak{R}_{kl,i} = I_{k,i}I_{l,i} + Q_{k,i}Q_{l,i}$$

$$\Delta\varphi_{mess,ij} = \arctan\left[\sum_{i=1}^{M}\mathfrak{I}_{kl,i} \Big/ \sum_{i=1}^{M}\mathfrak{R}_{kl,i}\right] ,$$

où

$V_{mess,k,i}$ est une tension d'antenne de l'antenne k,
$I_{mess,k,i}$ est une composante en phase de la tension d'antenne de l'antenne k,
$Q_{mess,k,i}$ est une composante en quadrature de la tension d'antenne de l'antenne k,
$P_{mess,k,i}$ est une puissance du signal électronique sans bruit,
$P_{noise}$ est une puissance de bruit,
$\sigma_{ist}^2(r_{mess,kl})$ est la variance de la première variable,
$r_{mess,kl}$ est la première variable, un rapport d'une puissance de réception entre le premier signal et le deuxième signal,
M est un nombre du nombre de valeurs du premier signal et du deuxième signal pris en compte,
i est un indice d'un nombre de valeurs du premier signal et du deuxième signal pris en compte,
k est un indice indiquant le premier signal,
l est un indice indiquant le deuxième signal,
$P_{k,obs,n}$ est une puissance observée au niveau de l'antenne k,
$P_{l,obs,n}$ est une puissance observée au niveau de l'antenne l,
$\sigma_{ist}^2(\Delta\varphi_{mess,kl})$ est la variance de la deuxième variable,
$\Delta\varphi_{mess,kl}$ est la deuxième variable, une différence de phase entre la phase du premier signal et la phase du deuxième signal,
$I_{k,i}$ est une composante en phase de la tension d'antenne de l'antenne k,
$Q_{l,i}$ est une composante en quadrature de la tension d'antenne de l'antenne l,
$I_{l,i}$ est une composante en phase de la tension d'antenne de l'antenne l,
$Q_{k,i}$ est une composante en quadrature de la tension d'antenne de l'antenne k,

$\mathfrak{I}_{kl,i}$ est une première variable auxiliaire, et

$\mathfrak{R}_{kl,i}$ est un deuxième variable auxiliaire.

**6.** Dispositif de mesure selon l'une quelconque des revendications 1 à 5,
**caractérisé en ce que**
le dispositif de mesure (1) comprend une troisième antenne, conçue pour recevoir le signal électromagnétique en tant que troisième signal,
la première variable et la deuxième variable sont successivement déduites

- du premier signal et du deuxième signal,
- du premier signal et du troisième signal, et
- du deuxième signal et du troisième signal,

l'unité de ligne de base (321) est conçue pour déterminer la variance de ligne de base, successivement pour la première variable et la deuxième variable déduites successivement
- du premier signal et du deuxième signal,
- du premier signal et du troisième signal, et
- du deuxième signal et du troisième signal,

l'unité de variance (322) est conçue pour déterminer la variance de la première variable et/ou de la deuxième variable, successivement pour la première variable et la deuxième variable déduites successivement
- du premier signal et du deuxième signal,
- du premier signal et du troisième signal, et
- du deuxième signal et du troisième signal, et

l'unité d'erreur (324) est conçue pour déterminer si une erreur systématique est présente, successivement sur la base de la variance de ligne de base et de la variance de la première variable et/ou de la deuxième variable déduites successivement
- du premier signal et du deuxième signal,
- du premier signal et du troisième signal, et
- du deuxième signal et du troisième signal.

**7.** Dispositif de mesure selon l'une quelconque des revendications 1 à 5,
**caractérisé en ce que**
le dispositif de mesure comprend une troisième antenne, conçue pour recevoir le signal électromagnétique en tant que troisième signal,
la première variable et la deuxième variable sont déduites du premier signal, du deuxième signal et du troisième signal.

**8.** Dispositif de mesure selon l'une quelconque des revendications 1 à 7,
**caractérisé en ce que**
le dispositif de mesure (1) comprend une unité de communication, conçue pour délivrer des informations concernant la présence et l'absence d'une erreur systématique dans le signal électromagnétique (4a) à un dispositif externe.

**9.** Dispositif de mesure selon l'une quelconque des revendications 1 à 8,
**caractérisé en ce que**
le dispositif de mesure (1) comprend une unité d'affichage (33), conçue pour afficher la présence et l'absence d'une erreur systématique dans le signal électromagnétique.

**10.** Dispositif de mesure selon la revendication 9, **caractérisé en ce que** l'unité d'affichage est conçue pour afficher la direction d'origine du signal électromagnétique.

**11.** Dispositif de mesure selon l'une quelconque des revendications 1 à 8,
**caractérisé en ce que**
le dispositif de mesure (1) comprend une unité d'affichage (33), conçue pour

- afficher la direction d'origine du signal électromagnétique (4a), de préférence en tant que ligne (332, 334) et/ou flèche pointant dans la direction du signal électromagnétique (4a), et
- afficher la présence et l'absence d'une erreur systématique dans le signal électromagnétique (4a), de préférence en tant que couleur et/ou forme et/ou ombrage et/ou transparence de la ligne et/ou de la flèche ou d'une forme (333, 335) attachée à une extrémité de la ligne et/ou de la flèche.

**12.** Dispositif de mesure selon la revendication 11,
**caractérisé en ce que**

l'unité d'affichage (33) est conçue pour afficher la direction d'origine du signal électromagnétique (4a), de préférence en tant que ligne (332) et/ou flèche pointant dans la direction du signal électromagnétique (4a), uniquement si l'unité d'erreur (324) a déterminé qu'une erreur systématique n'est pas présente dans le signal électromagnétique (4a).

13. Procédé pour mesurer la direction d'origine d'un signal électromagnétique, comprenant les étapes suivantes :

- réception (100) du signal électromagnétique par une première antenne (21) en tant que premier signal,
- réception (100) du signal électromagnétique par une deuxième antenne en tant que deuxième signal,
- détermination (101) d'une variance de ligne de base d'une première variable et/ou d'une deuxième variable, alors que le premier signal et le deuxième signal ne sont pas reçus, en prenant uniquement le bruit de fond en considération pour déterminer la variance de ligne de base de la première variable et/ou de la deuxième variable, dans lequel la première variable est un rapport entre une puissance d'un point de mesure du premier signal et une puissance d'un point de mesure simultané du deuxième signal, et la deuxième variable est une différence de phase entre un point de mesure du premier signal et un point de mesure simultané du deuxième signal,
- détermination (104) d'une variance de la première variable et/ou de la deuxième variable, et
- détermination (105) si une erreur systématique est présente, sur la base de la variance de ligne de base et de la variance de la première variable et/ou de la deuxième variable, dans lequel l'erreur systématique fait référence à une erreur dans le signal électromagnétique due à une propagation multitrajet lors de la détermination de la direction d'origine du signal électromagnétique.

14. Programme d'ordinateur avec des moyens formant code de programme pour effectuer toutes les étapes selon la revendication 13 lorsque le programme est exécuté sur un processeur de signaux d'un dispositif de mesure conçu pour mesurer la direction d'origine d'un signal électromagnétique, comprenant une unité de traitement (32), une première antenne (21), conçue pour recevoir le signal électromagnétique en tant que premier signal, et une deuxième antenne (22), conçue pour recevoir le signal électromagnétique en tant que deuxième signal.

**Fig. 1**

**Fig. 2**

27

4

21

22

**Fig. 3a**

P

$P_{21}$

$P_{22}$

t

**Fig. 3b**

$P_{22}$

$r_{21, 22}$

$P_{21}$

**Fig. 3c**

27

4a

5

21

22

**Fig. 4a**

P

$P_{22}$

$P_{21}$

t

**Fig. 4b**

$P_{22}$

$r_{21, 22}$

$P_{21}$

**Fig. 4c**

Fig. 5

Fig. 6

Fig. 7

Receive background noise signal
by at least two antennas — 100

Determine baseline variance of
power ratio and/or phase difference
of background noise — 101

Determine variance threshold(s) — 102

Receive electromagnetic signal
by the at least two antennas — 103

Determine variance of
power ratio and/or phase difference
of electromagnetic signal — 104

Compare variance(s)
to baseline variance(s) — 105

Variance(s)
< Threshold(s)

Variance(s)
> Threshold(s)

Determine electromagnetic signal
as not suffering from systematic error

Determine electromagnetic signal
as suffering from systematic error

106a

Display and/or output measuring signal
including systematic error status — 107

106b

Fig. 8

**EP 3 147 683 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2014135196 A1
- US 5526001 A
- US 5457466 A